# EUROPEAN PATENT APPLICATION

(11) **EP 4 312 237 A1**
(43) Date of publication of application: **31.01.2024**
(21) Application number: 22187595.8
(22) Date of filing: 28.07.2022
(51) Int. Cl.: H01F 27/06, H01F 37/00, H02M 1/00, H05K 1/18

(54) **MULTI-PHASE POWER CONVERTER**

(71) Applicant: Infineon Technologies Austria AG, 9500 Villach (AT)
(72) Inventor: KESSLER, Angela, 93161 Sinzing (DE); MEYER, Thorsten, 93053 Regensburg (DE); SCHARF, Thorsten, 93137 Lappersdorf (DE)
(74) Representative: Infineon Patent Department

(57) **Abstract**

The present document relates to multi-phase power converters. In particular, the present document relates to a multi-phase power converter comprising a first phase with a first power stage and a first inductor, a second phase with a second power stage and a second inductor, and a first substrate extending along a first substrate plane. The first power stage, the first inductor and the second inductor may be arranged above the first substrate. The second power stage may be arranged below the first substrate. By arranging the two power stages vertically shifted on different sides of the first substrate, it becomes possible to save space in the substrate plane and thus decrease the horizontal space required for a given number of phases of the multi-phase power converter

## Description

### Technical Field

The present document relates to power converters. In particular, the present document relates to multi-phase power converters comprising a plurality of phases for providing high output currents.

### Background

A clear trend for integration can be seen for power modules. At this, power modules have evolved from integrated single-phase power converters, through integrated dual-phase power converters to integrated multi-phase power converters. With increasing efficiency and level of integration, the current flow changes. For integrated multi-phase power converters, the current flow is expected to be mainly vertical. In other words, a plurality of phases of a multi-phase power converter is located below a load plane (such as e.g. a compute plane of a supercomputer), and the supply currents are essentially flowing vertically upwards through respective power stages and inductors towards the compute plane. Especially the space restrictions for the power stages lead to very dense constructions and the size of the power stages becomes a limiting factor when the number of phases needs to be increased for a given size of the overall power module.

The present document addresses the above-mentioned technical problems. In particular, the present document addresses the technical problem of providing a power module with an improved arrangement of power stages within a multi-phase power converter.

### Summary

According to an aspect, a multi-phase power converter circuit is presented. The multi-phase power converter may comprise a first phase with a first power stage and a first inductor, a second phase with a second power stage and a second inductor. The multi-phase power converter may comprise a first substrate extending along a first substrate plane. The first power stage, the first inductor and the second inductor may be arranged above the first substrate. The second power stage may be arranged below the first substrate. As will be explained in the following description, the both power stages may or may not be directly attached to the first substrate.

The described multi-phase power converter may be part of a two-stage power conversion. The first stage may convert from e.g. ∼50V to ∼10 V. The second stage, i.e. the multi-phase power converter presented within this document, may convert from the 10 to ∼1V or different voltages ranging from 0.5-1.5 V.

The first substrate may comprise e.g. a printed circuit board (PCB). Without loss of generality, the first substrate plane may also be denoted as first horizontal plane and a direction perpendicular to the first substrate plane may be regarded as a vertical direction. By arranging the two power stages vertically shifted on different sides of the first substrate, it becomes possible to save space in the horizontal plane and thus decrease the horizontal space required for a given number of phases of the multi-phase power converter. In other words, the proposed arrangement enables horizontal area reductions at the expense of increased vertical thickness of the multiphase-power converter. This may be in particular beneficial for power converters with a plurality of phases (such as e.g. 25 or more) and high output currents of up to 1000A or more.

The first power stage and the second power stage may at least partly overlap in a vertical direction, wherein the vertical direction is substantially perpendicular to the first substrate plane. As a result, the required horizontal space is reduced compared to a scenario in which both power stages are arranged next to each other in the same plane on the same side of the first substrate without any overlap. The larger the overlap, the larger the horizontal space savings.

At least a part of the first substrate may be arranged between the first power stage and the second power stage. For instance, if the multi-phase power converter comprises only the first substrate and no further (e.g. second) substrate, at least a part of the first substrate may be sandwiched between the first power stage and the second power stage. In other words, the first power stage may be attached to a top surface of the first substrate, the second power stage may be attached to a bottom surface of the first substrate, and at least a part of the first substrate may be sandwiched between the first power stage and the second power stage.

The first power stage may have the shape of a cuboid, and more particularly the shape of a (flat) rectangular cuboid, wherein one of the two largest faces of that rectangular cuboid may be attached to the top surface of the first substrate. The latter face may also be denoted as footprint of the first power stage. Similarly, the second power stage may also have the shape of a cuboid, and more particularly the shape of a (flat) rectangular cuboid, wherein one of the two largest faces of that rectangular cuboid may be attached to the bottom surface of the first substrate. The latter face may also be denoted as footprint of the second power stage. Thus, it becomes evident that the footprint of the first power stage and the footprint of the second power stage may overlap in the vertical direction on both sides of the first substrate.

The multi-phase power converter may further comprise at least one capacitive element attached to the bottom surface of the first substrate. The capacitive element may be e.g. a capacitor or another device capable of storing electrical energy in an electric field. The capacitive element may be an input capacitor electrically coupled to the first power stage or the second power stage. Alternatively, the capacitive element may be an output capacitor electrically coupled to the first inductor or the second inductor.

The multi-phase power converter may further comprise a second substrate extending along a second substrate plane. The second substrate may comprise e.g. a printed circuit board (PCB). The first power stage may be attached to a top surface of the first substrate, the second power stage may be attached to a top surface of the second substrate, and at least a part of the first substrate may be arranged between the first power stage and the second power stage. Again, in case the first power stage has the shape of a (flat) rectangular cuboid, one of the two largest faces (i.e. the footprint) of that rectangular cuboid may be attached to the top surface of the first substrate. And, in case the second power stage has the shape of a (flat) rectangular cuboid, one of the two largest faces (i.e. the footprint) of that rectangular cuboid may be attached to the top surface of the second substrate. The second substrate may be arranged such that the second substrate plane is substantially parallel to the first substrate plane. In general, even higher densities may be achieved by using three or more substrates layers which are parallel to the first substrate plane.

The multi-phase power converter may comprise at least one capacitive element attached to the top surface of the first substrate. Alternatively or additionally, the multi-phase power converter may comprise at least one capacitive element attached to the top surface of the second substrate.

Moreover, the multi-phase power converter may comprise a third substrate extending along a third substrate plane, wherein said third substrate plane is substantially perpendicular to the first substrate plane. The third substrate may comprise e.g. a printed circuit board (PCB). The third substrate plane may be substantially perpendicular to the second substrate plane. For example, the third substrate plane may comprise passive circuit elements and/or control circuitry.

The first inductor may be arranged above the first power stage and may be electrically connected to a switching node of the first power stage. The second inductor may be arranged above the second power stage and may be electrically connected to a switching node of the second power stage. A load plane (or compute plane) may be arranged above the first inductor and the second inductor. The load plane may be substantially parallel to the first substrate plane. If a second substrate is implemented, said load plane may also be substantially parallel to the second substrate plane.

The first substrate may comprise a through-hole for establishing an electrical connection between the second power stage and the second inductor. More specifically, the first substrate may comprise the through-hole for the passage of a cylindrical, electrically conductive path of the second inductor.

The first inductor may comprise a first non-winding electrically conductive path, and the second inductor may comprise a second non-winding electrically conductive path. An axis of the first non-winding electrically conductive path and an axis of the second non-winding electrically conductive path may be substantially parallel. It should be mentioned that both axes are virtual axes for defining geometrical relationships between the different components. Like all axes mentioned within this document, said axes may not be implemented as physical axes in an embodiment of the present invention.

For example, the first non-winding electrically conductive path may be a cylindrical conductor, and the axis of the first non-winding electrically conductive path may be the symmetry axis of this cylindrical conductor.

Likewise, the second non-winding electrically conductive path may be a cylindrical conductor, and the axis of the second non-winding electrically conductive path may be the symmetry axis of this cylindrical conductor.

The first inductor may comprise magnetic material surrounding the first non-winding electrically conductive path. The second inductor may comprise magnetic material surrounding the second non-winding electrically conductive path. Both magnetic materials may be separated from each other and may both have a tubular structure. Alternatively, both magnetic materials may form part of a single magnetic structure enclosing both conductive paths. The magnetic materials may comprise the usual materials like ferrites or ferromagnetic materials, mainly alloys of Fe, Ni, (Co) or Fe, Al, and Si. Many other materials are possible.

The axis of the first non-winding electrically conductive path may be substantially perpendicular to the first substrate plane. Analogously, the axis of the second non-winding electrically conductive path may be substantially perpendicular to the first substrate plane.

The first power stage may extend along a first plane, and the second power stage may extend along a second plane. The first plane, the second plane and the first substrate plane may be substantially parallel.

In general, the first power stage may comprise a half-bridge and driver circuitry. The half-bridge may comprise a high-side switching element and a low-side switching element, and the driver circuitry may be configured to drive voltages at control terminals of the high-side switching element and a low-side switching element, respectively. The switching elements as well as the driver circuitry may be integrated using Chip Embedding (CE) techniques. The first power stage and the second power stage may be identical.

The high-side switching element and the low-side switching element may be implemented with any suitable device, such as, for example, a metal-oxide-semiconductor field effect transistor MOSFET, an insulated-gate bipolar transistor IGBT, a MOS-gated thyristor, or any other suitable power device. For instance, the switching elements may be implemented using III-V semiconductors such as e.g. GaN-HEMTs. Each switching element may have a gate to which a respective driving voltage or control signal may be applied to turn the switching element on (i.e. to close the switching element) or to turn the switching element off (i.e. to open the switching element).

Each phase of the multi-phase power converter may implement a buck power converter and each phase may be turned on/off according to an activation scheme. Each buck power converter may be configured to regulate an output voltage/current provided to the load plane based on an input voltage/current which is applied to the high-side switching element of the first power stage and to the high-side switching element of the second power stage. At this, the output voltage of each buck power converter may be lower than the input voltage. Within each power stage, the high-side switching element may be coupled between said input voltage and a respective switching node, and the low-side switching element may be coupled between said respective switching node and a reference potential. The switching nodes of the power stages may be located at the top of the power stages for connecting the power stages to their respective inductors.

Throughout this document, the term "reference potential" is meant in its broadest possible sense. In particular, the reference potential is not limited to ground i.e. a reference potential with a direct physical connection to earth or a voltage of OV. Rather, the term "reference potential" may refer to any reference point to which and from which electrical currents may flow or from which voltages may be measured. Moreover, it should be mentioned that the reference potentials mentioned in this document (and in particular the reference potentials of the different phases) may not necessarily refer to the same physical contact. Instead, the reference potentials mentioned in this document may relate to different physical contacts although reference is made to "the" reference potential for ease of presentation.

According to another aspect, a method of producing a multi-phase power converter is described. The method may comprise steps which correspond to the features of the multi-phase power converter described in the present document.

More specifically, the present document discloses a method for a multi-phase power converter comprising a first phase with a first power stage and a first inductor, a second phase with a second power stage and a second inductor, and a first substrate extending along a first substrate plane. The method may comprise arranging the first power stage, the first inductor and the second inductor above the first substrate. The method may comprise arranging the second power stage below the first substrate.

The method may comprise arranging the first power stage and the second power stage such that the first power stage and the second power stage at least partly overlap in a vertical direction, wherein the vertical direction is substantially perpendicular to the first substrate plane. The method may comprise arranging at least a part of the first substrate between the first power stage and the second power stage. In particular, the method may comprise sandwiching at least a part of the first substrate between the first power stage and the second power stage.

The method may comprise providing a through-hole through the first substrate for establishing an electrical connection between the second power stage and the second inductor. To be more specific, the method may comprise arranging a cylindrical, electrically conductive path of the second inductor in the through-hole of the first substrate for establishing said electrical connection.

It should be noted that the methods and systems including its preferred embodiments as outlined in the present document may be used stand-alone or in combination with the other methods and systems disclosed in this document. In addition, the features outlined in the context of a system are also applicable to a corresponding method. Furthermore, all aspects of the methods and systems outlined in the present document may be arbitrarily combined. In particular, the features of the claims may be combined with one another in an arbitrary manner. In the present document, the term "couple" or "coupled" refers to elements being in electrical communication with each other, whether directly connected e.g., via wires, or in some other manner.

### Short description of the Figures

The present invention is illustrated by way of example, and not by way of limitation, in the figures of the accompanying drawings in which like reference numerals refer to similar or identical elements, and in which
Fig. 1 shows a side-view of a first embodiment of the proposed multi-phase power converter;
Fig. 2 shows a side-view of a second embodiment of the proposed multi-phase power converter;
Fig. 3 shows an angled view of the second embodiment of the proposed multi-phase power converter;
Fig. 4 shows an angled view focusing on the second substrate plane of the second embodiment of the proposed multi-phase power converter;
Fig. 5 shows a top view focusing on the second (bottom) substrate plane of the second embodiment of the proposed multi-phase power converter;
Fig. 6 shows an angled view focusing on the first (top) substrate plane of the second embodiment of the proposed multi-phase power converter; and
Fig. 7 shows a top view focusing on the first (top) substrate plane of the second embodiment of the proposed multi-phase power converter.

### Detailed Description

As already mentioned in the foregoing description, in a multi-phase power converter with vertical current flow, the required number of single power stages may be distributed in multiple planes in order to allow the application of all components (actives and passives) with conditions as similar as possible for all power stages. That is, it becomes possible to arrange the same type of power stage in a space-efficient manner within the vertical current flow of a multi-phase power converter.

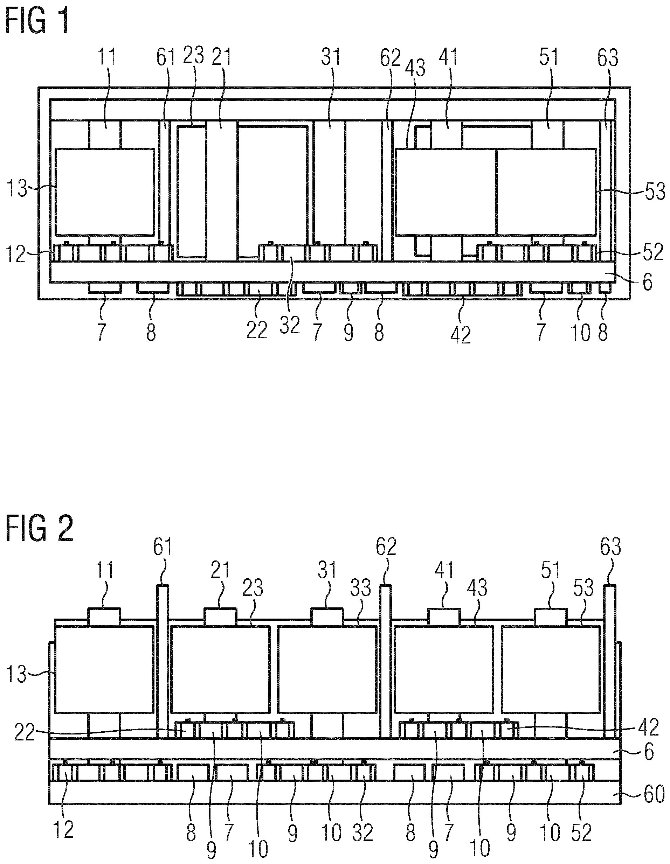

Fig. 1 shows a side-view of a first embodiment of the proposed multi-phase power converter. This first embodiment may be seen as a single PCB proposal as only one horizontal PCB 6 (first substrate) is used. In this side-view, five phases of the exemplary power converter are visible: A first phase comprises an inductor with a copper core 11 and magnetic material 13 as well as a power stage 12 which is mounted on the top surface (top assembly plane) of PCB 6 (substrate). A second phase comprises an inductor with a copper core 21 and magnetic material 23 as well as a power stage 22 which is mounted on the bottom surface (bottom assembly plane) of PCB 6. A third phase comprises an inductor with a copper core 31 and magnetic material (not illustrated) as well as a power stage 32 which is again mounted on the top surface of PCB 6. A fourth phase comprises an inductor with a copper core 41 and magnetic material 43 as well as a power stage 42 which is mounted on the bottom surface of PCB 6. Finally, a fifth phase comprises an inductor with a copper core 51 and magnetic material 53 as well as a power stage 52 which is mounted on the top surface of PCB 6. All power stages illustrated in Fig. 1 may be power stages in a chip embedding technology (e.g. in laminate or mold). The power stages may be e.g. Denali HD power stages. For instance, the power stage may be a modified Denali HD capable of providing current on one side and having logic contacts on the opposite side. The power stages of phases 1, 3, and 5 are arranged in a plane above the (first) substrate plane defined by PCB 6, and phases 2 and 4 are arranged in a plane below the substrate plane.

As can be seen Fig. 1, the different inductors may be separated by lateral walls 61, 62, 63 which may be e.g. current carrying metal sheets. Fig. 1 also shows power current rails 7 and ground current rails 9 at the bottom side of PCB 6, and decoupling capacitors 9 and 10 at the bottom side of PCB 6.

Fig. 2 shows a side-view of a second embodiment of the proposed multi-phase power converter. This second embodiment may be regarded as a dual PCB proposal as - in addition to the first PCB 6 - a second PCB 60 (second substrate) is provided below the first PCB 6. In this side-view, five phases of the exemplary power converter are visible: A first phase comprises a first inductor with a copper core 11 and magnetic material 13 as well as a power stage 12 which is mounted on the top surface (top assembly plane) of the second PCB 60 (second substrate). The first PCB 6 provides a through-hole, and the cylindrical copper core 11 of the first inductor is positioned within this through-hole such that the inductor current flows vertically upwards from the power stage 12 via the copper core 11 to the load plane (not illustrated in Fig. 2). A second phase comprises an inductor with a copper core 21 and magnetic material 23 as well as a power stage 22 which is mounted on the top surface (top assembly plane) of PCB 6. A third phase comprises an inductor with a copper core 31 and magnetic material 33 as well as a power stage 32 which is again mounted on the top surface of the second PCB 60. A fourth phase comprises an inductor with a copper core 41 and magnetic material 43 as well as a power stage 42 which is mounted on the top surface of the first PCB 6. Finally, a fifth phase comprises an inductor with a copper core 51 and magnetic material 53 as well as a power stage 52 which is mounted on the top surface of the second PCB 60. Again, all power stages illustrated in Fig. 1 may be power stages in a chip embedding technology (e.g. in laminate or mold) such as e.g. Denali HD power stages or modified Denali HD power stages as described in the forgoing description. The power stages of phases 1, 3, and 5 are arranged in a plane above the (first) substrate plane defined by PCB 6, and phases 2 and 4 are arranged in a plane below the substrate plane.

All power stages illustrated in Fig. 2 may be power stages in a chip embedding technology (e.g. in laminate or mold) such as e.g. Denali HD power stages or modified Denali HD power stages. The power stages of phases 1, 3, and 5 are arranged in a plane above the first substrate plane defined by first PCB 6, and phases 2 and 4 are arranged in a plane above the second substrate plane defined by the second PCB 60.

As can be seen Fig. 2, the different inductors may be separated by lateral walls 61, 62, 63 which may be e.g. current carrying metal sheets. Fig. 2 also shows power current rails 7 and ground current rails 9 at the bottom side of PCB 6, and decoupling capacitors 9 and 10 at the top sides of the first PCB 6 and the second PCB 60.

In summary, the main differences between the first and the second embodiment are (a) the additional, second PCB 60 of the second embodiment, (b) the attachment of the lower power stages to the top surface of the second PCB 60 in the second embodiment, and (c) the attachment of the decoupling capacitors 9, 10 to the top surfaces of the first PCB6 and the second PCB 60 in the second embodiment.

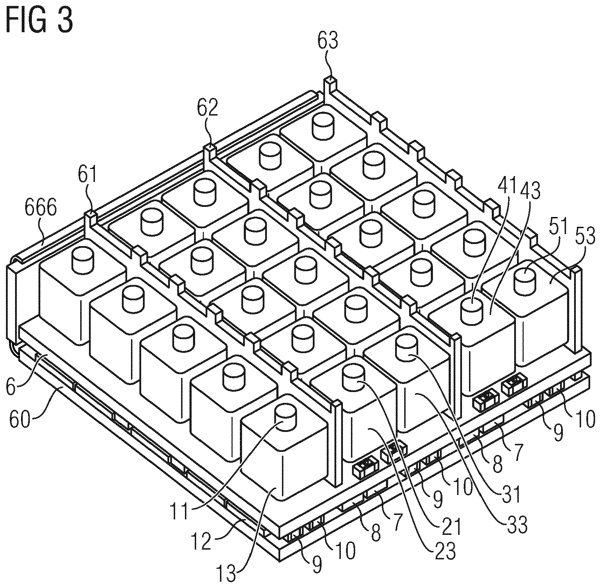

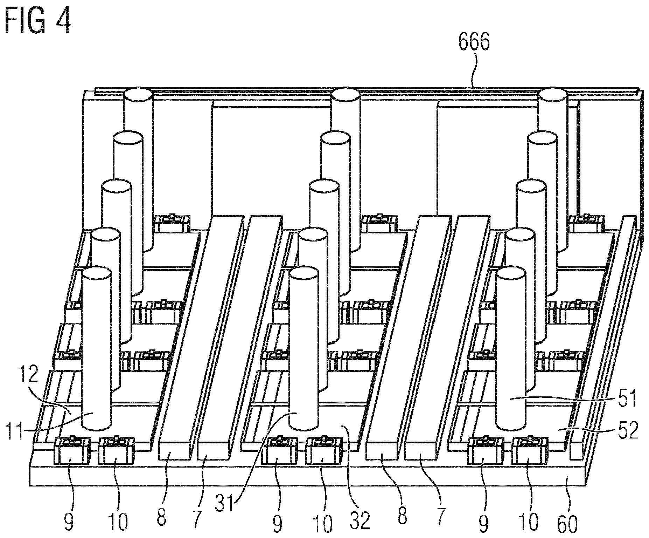

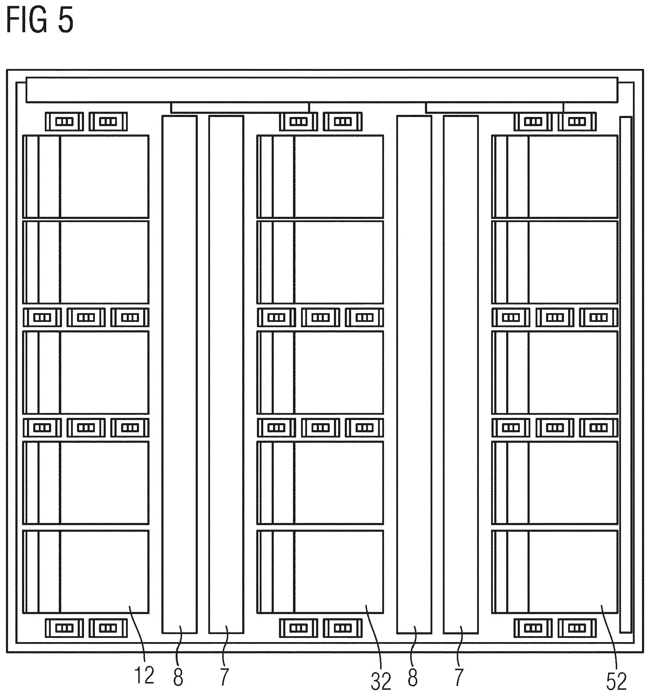

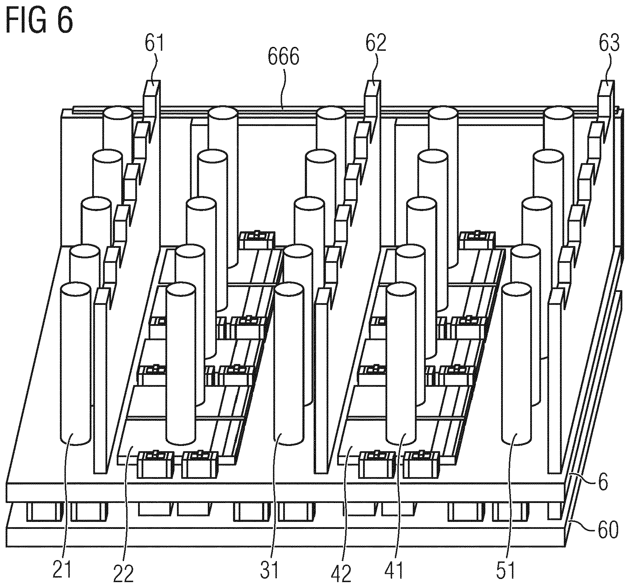

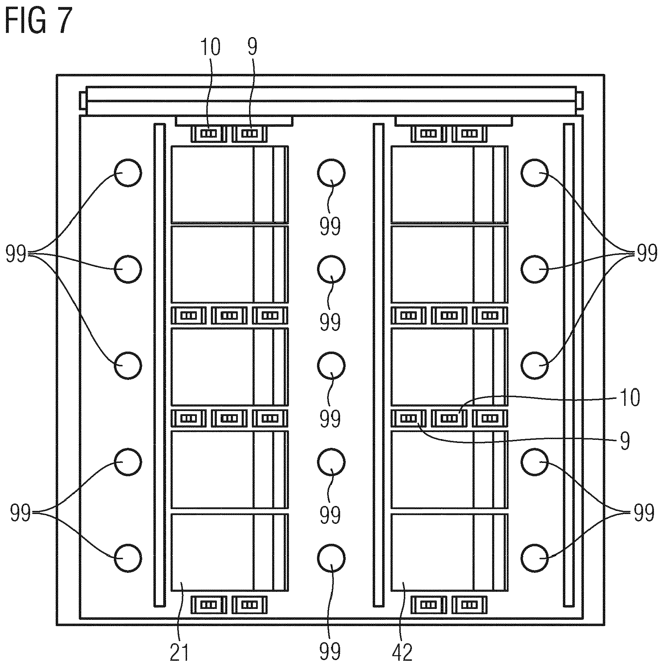

Fig. 3 shows an angled view of the second embodiment of the proposed multi-phase power converter. In Fig. 3, an optional third substrate 666 (PCB) extending along a third substrate plane is illustrated, wherein said third substrate plane is substantially perpendicular to the first substrate plane of PCB 6. In addition, the power converter may comprise a further substrate/PCB on top of the whole arrangement (not shown in Fig. 3), e.g. atop the inductors. Said further substrate may on the one hand comprise the output capacitors and on the other hand route the current to the desired positions. Fig. 4 shows an angled view focusing on the second substrate plane of the second embodiment of the proposed multi-phase power converter. Fig. 5 shows a top view focusing on the second (bottom) substrate plane of the second embodiment of the proposed multi-phase power converter. Fig. 6 shows an angled view focusing on the first (top) substrate plane of the second embodiment of the proposed multi-phase power converter. Fig. 7 shows a top view focusing on the first (top) substrate plane of the second embodiment of the proposed multi-phase power converter.

In the design presented so far, the application of at one microcontroller is not discussed yet. Microcontrollers may be arranged in a rigid part of a rigid flex board. Those boards contain flexible, bendable parts and rigid parts for assembly of components. So overall, the power converter may also comprise at least one flex board with a controller. In general, the power converter may comprise a plurality of flex boards with one controller each. One controller may control the top PCB, one the bottom, alternatively also only one flexible part over the whole length is possible, but may be assembled on both sides before bending. Additionally, also a further part of this rigid flex board could form a top PCB, which is bent and connected to the vertical ground rails and the top of the inductors. This PCB may route the communication between a CPU tile and the controllers, distribute the current horizontally to the inputs of the CPU and host the output voltage capacitors, preferably facing the inductors.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

Some of the aspects explained above are summarized in the following by way of numbered examples.

Example 1. A multi-phase power converter comprising a first phase with a first power stage and a first inductor, a second phase with a second power stage and a second inductor, and a first substrate extending along a first substrate plane, wherein the first power stage, the first inductor and the second inductor are arranged above the first substrate, and wherein the second power stage is arranged below the first substrate.

Example 2. The multi-phase power converter according to example 1, wherein the first power stage and the second power stage at least partly overlap in a vertical direction, wherein the vertical direction is substantially perpendicular to the first substrate plane.

Example 3. The multi-phase power converter according to example 1 or 2, wherein at least a part of the first substrate is arranged between the first power stage and the second power stage.

Example 4. The multi-phase power converter according to any one of the preceding examples, wherein the first power stage is attached to a top surface of the first substrate, wherein the second power stage is attached to a bottom surface of the first substrate, and wherein at least a part of the first substrate is sandwiched between the first power stage and the second power stage.

Example 5. The multi-phase power converter according to example 4, further comprising at least one capacitive element attached to the bottom surface of the first substrate.

Example 6. The multi-phase power converter according to any one of examples 1 to 3, further comprising a second substrate extending along a second substrate plane, wherein the first power stage is attached to a top surface of the first substrate, wherein the second power stage is attached to a top surface of the second substrate, and wherein at least a part of the first substrate is arranged between the first power stage and the second power stage.

Example 7. The multi-phase power converter according to example 6, further comprising at least one capacitive element attached to the top surface of the first substrate.

Example 8. The multi-phase power converter according to example 6 or 7, further comprising at least one capacitive element attached to the top surface of the second substrate.

Example 9. The multi-phase power converter according to any one of the preceding examples, further comprising a third substrate extending along a third substrate plane, wherein said third substrate plane is substantially perpendicular to the first substrate plane.

Example 10. The multi-phase power converter according to any one of the preceding examples, wherein the first inductor is arranged above the first power stage and electrically connected to a switching node of the first power stage, and wherein the second inductor is arranged above the second power stage and electrically connected to a switching node of the second power stage.

Example 11. The multi-phase power converter according to any one of the preceding examples, wherein the first substrate comprises a through-hole for establishing an electrical connection between the second power stage and the second inductor.

Example 12. The multi-phase power converter according to example 11, wherein the first substrate comprises the through-hole for the passage of a cylindrical, electrically conductive path of the second inductor.

Example 13. The multi-phase power converter according to any one of the preceding examples, wherein the first inductor comprises a first non-winding electrically conductive path, wherein the second inductor comprises a second non-winding electrically conductive path, and wherein an axis of the first non-winding electrically conductive path and an axis of the second non-winding electrically conductive path are substantially parallel.

Example 14. The multi-phase power converter according to example 13, wherein the axis of the first non-winding electrically conductive path is substantially perpendicular to the first substrate plane.

Example 15. The multi-phase power converter according to any one of the preceding examples, wherein the first power stage extends along a first plane, and the second power stage extends along a second plane, and wherein the first plane, the second plane and the first substrate plane are substantially parallel.

Example 16. The multi-phase power converter according to any one of the preceding examples, wherein the first power stage comprises a half-bridge and driver circuitry.

Example 17. The multi-phase power converter according to example 16, wherein the half-bridge comprises a high-side switching element and a low-side switching element, and wherein the driver circuitry is configured to drive voltages at control terminals of the high-side switching element and a low-side switching element, respectively.

Example 18. The multi-phase power converter according to any one of the preceding examples, wherein the first power stage and the second power stage are identical.

Example 19. A method of producing a multi-phase power converter comprising a first phase with a first power stage and a first inductor, a second phase with a second power stage and a second inductor, and a first substrate extending along a first substrate plane, the method comprising arranging the first power stage, the first inductor and the second inductor above the first substrate, and arranging the second power stage below the first substrate.

Example 20. The method according to example 19, comprising arranging the first power stage and the second power stage such that the first power stage and the second power stage at least partly overlap in a vertical direction, wherein the vertical direction is substantially perpendicular to the first substrate plane.

Example 21. The method according to example 19 or 20, comprising arranging at least a part of the first substrate between the first power stage and the second power stage.

Example 22. The method according to example 19 or 20, comprising sandwiching at least a part of the first substrate between the first power stage and the second power stage.

Example 23. The method according to any one of examples 19 to 22, comprising providing a through-hole through the first substrate for establishing an electrical connection between the second power stage and the second inductor.

Example 24. The method according to example 23, comprising arranging a cylindrical, electrically conductive path of the second inductor in the through-hole of the first substrate.

## Claims

1. A multi-phase power converter comprising a first phase with a first power stage and a first inductor, a second phase with a second power stage and a second inductor, and a first substrate extending along a first substrate plane, wherein
- the first power stage, the first inductor and the second inductor are arranged above the first substrate, and
- the second power stage is arranged below the first substrate.

2. The multi-phase power converter according to claim 1, wherein the first power stage and the second power stage at least partly overlap in a vertical direction, wherein the vertical direction is substantially perpendicular to the first substrate plane.

3. The multi-phase power converter according to claim 1 or 2, wherein
at least a part of the first substrate is arranged between the first power stage and the second power stage.

4. The multi-phase power converter according to any one of the preceding claims, wherein the first power stage is attached to a top surface of the first substrate, wherein the second power stage is attached to a bottom surface of the first substrate, and wherein at least a part of the first substrate is sandwiched between the first power stage and the second power stage.

5. The multi-phase power converter according to claim 4, further comprising at least one capacitive element attached to the bottom surface of the first substrate.

6. The multi-phase power converter according to any one of claims 1 to 3, further comprising a second substrate extending along a second substrate plane, wherein the first power stage is attached to a top surface of the first substrate, wherein the second power stage is attached to a top surface of the second substrate, and wherein at least a part of the first substrate is arranged between the first power stage and the second power stage.

7. The multi-phase power converter according to claim 6, further comprising at least one capacitive element attached to the top surface of the first substrate.

8. The multi-phase power converter according to claim 6 or 7, further comprising at least one capacitive element attached to the top surface of the second substrate.

9. The multi-phase power converter according to any one of the preceding claims, further comprising a third substrate extending along a third substrate plane, wherein said third substrate plane is substantially perpendicular to the first substrate plane.

10. The multi-phase power converter according to any one of the preceding claims, wherein the first inductor is arranged above the first power stage and electrically connected to a switching node of the first power stage, and wherein the second inductor is arranged above the second power stage and electrically connected to a switching node of the second power stage.

11. The multi-phase power converter according to any one of the preceding claims, wherein the first substrate comprises a through-hole for establishing an electrical connection between the second power stage and the second inductor.

12. The multi-phase power converter according to claim 11, wherein the first substrate comprises the through-hole for the passage of a cylindrical, electrically conductive path of the second inductor.

13. The multi-phase power converter according to any one of the preceding claims, wherein the first inductor comprises a first non-winding electrically conductive path, wherein the second inductor comprises a second non-winding electrically conductive path, and wherein an axis of the first non-winding electrically conductive path and an axis of the second non-winding electrically conductive path are substantially parallel.

14. The multi-phase power converter according to claim 13, wherein the axis of the first non-winding electrically conductive path is substantially perpendicular to the first substrate plane.

15. A method of producing a multi-phase power converter comprising a first phase with a first power stage and a first inductor, a second phase with a second power stage and a second inductor, and a first substrate extending along a first substrate plane, the method comprising
- arranging the first power stage, the first inductor and the second inductor above the first substrate, and
- arranging the second power stage below the first substrate.
